(19) Europäisches Patentamt

European Patent Office

Office européen des brevets

(11) **EP 0 484 096 B1**

## (12) EUROPEAN PATENT SPECIFICATION

(45) Date of publication and mention
of the grant of the patent:
**02.04.1997 Bulletin 1997/14**

(51) Int Cl.$^6$: **H01L 21/338**, H01L 29/812,
H01L 29/41

(21) Application number: **91309970.1**

(22) Date of filing: **29.10.1991**

(54) **Method of making recessed T-shaped Schottky gate field effect transistor**

Verfahren zur Herstellung von Feldeffekttransistoren mit einem eingefügten T-förmigen Schottky
Gatter

Procédé pour fabriquer un transistor à effet de champ ayant une porte Schottky en forme de T et
encastrée

(84) Designated Contracting States:
**DE FR GB**

(30) Priority: **30.10.1990 JP 296634/90**

(43) Date of publication of application:
**06.05.1992 Bulletin 1992/19**

(60) Divisional application: **95200806.8**

(73) Proprietor: **MITSUBISHI DENKI KABUSHIKI
KAISHA
Tokyo (JP)**

(72) Inventor: **Nakatani, Mitsunori,
c/o Mitsubishi Denki K.K.
1, Mizuhara 4-chome Itami-shi, Hyogo-ken (JP)**

(74) Representative:
**Beresford, Keith Denis Lewis et al
BERESFORD & Co.
2-5 Warwick Court
High Holborn
London WC1R 5DJ (GB)**

(56) References cited:
**EP-A- 0 064 745          EP-A- 0 113 161
EP-A- 0 308 939**

- **PATENT ABSTRACTS OF JAPAN vol. 13, no. 453
(E-831)(3801) 12 October 1989&JP-A-11 75 772**

## Description

<u>FIELD OF THE INVENTION</u>

The present invention relates to a method for fabricating a semiconductor device and, more particularly, to a method for fabricating a field effect transistor having an offset T-shaped gate electrode in a two-stepped recess.

<u>BACKGROUND OF THE INVENTION</u>

Field effect transistors (FET's) employing compound semiconductors, such as galium arsenide (GaAs) or indium phosphide (InP) are useful as high frequency transistors because electron mobilities in these compound semiconductors are relatively high.

Recently, FET's having a gate electrode formed in a recess of an active layer have been employed to realize a high breakdown voltage and a high speed operation.

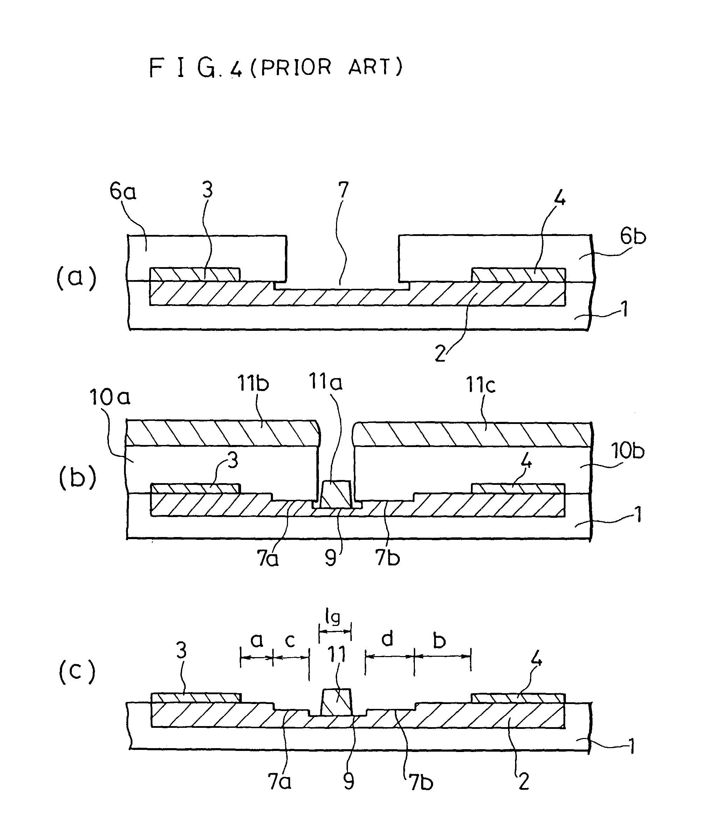

A method for fabricating a conventional FET having a gate electrode formed in a two-stepped recess of an active layer (hereinafter referred to as a two-stepped recess gate structure) is illustrated in Figures 4 (a) to 4 (c). In figure 5, a semi-insulating substrate 1 is formed of GaAs or the like. An active layer 2 is formed on a surface of the substrate 1. A source electrode 3 and a drain electrode 4 are formed of metal being in ohmic contact with the substrate 1. Reference numerals 7 (further 7a and 7b) designates an upper stepped recess and reference numeral 9 designates a lower stepped recess. Resists 6a and 6b are used for forming the upper stepped recess 7 and resists 10a and 10b are used for forming the lower stepped recess 9. Gate electrode metal 11a, 11b and 11c is deposited and a gate electrode 11, in Schottky contact with the substrate 1, is produced from the gate electrode metal 11a.

The fabricating method will be described.

First, as shown in figure 4 (a), an active layer 2 is produced at a desired position in a semi-insulating substrate 1 by ion implantation or epitaxial growth. Then, a source electrode 3 and a drain electrode 4 are formed on the active layer 2 in ohmic contact with the active layer 2 and patterns of photoresist 6a and 6b are formed to be used for recess-etching a part of the active layer 2 between the source electrode 3 and the drain electrode 4. Then, an upper stepped recess 7 is formed by recess-etching.

Next, as shown in figure 4(b), patterns of photoresist 10a and 10b are formed to be used for further recess-etching a part of the active layer 2 at the surface of the upper stepped recess 7 and then a lower stepped recess 9 is formed. Thereafter, gate electrode metals 11b, 11c and 11a are deposited on the resist patterns 10a and 10b and the lower stepped recess 9, respectively, separated from each other.

Next, as shown in figure 4(c), the resist patterns 10a and 10b and the gate electrode metals 11b and 11c are removed by lift-off and only the gate electrode 11 is left on the lower stepped recess 9. Thus, an FET having a two-stepped recess gate structure is completed.

According to this fabricating method, alignment of the resist patterns 6a and 6b and 10a and 10b with the substrate 1 is shifted to some degree due to the performance of an exposure apparatus. For example, as shown in figure 4(c), when the distance between an end of the source electrode 3 and the upper stepped recess 7 and the distance between an end of the drain electrode 4 and the upper stepped recess 7 are indicated by a and b, respectively and the width of the upper stepped recess 7 on the side of the source electrode 3 and the width of the upper stepped recess 7 on the side of the drain electrode 4 are indicated by c and d, respectively, even when the condition that a = b and c = d is required, the following relations

$$| a - b | \leqq \alpha$$

$$| c - d | \leqq \alpha$$

result due to the shift of alignment, where $+\alpha$ is mask alignment precision of the exposure apparatus.

When $\alpha = \pm 0.3$ micrometer (micron), in order to satisfy the condition that a, b, c, d > 0, i.e., in order to prevent the source electrode 3 and the drain electrode 4 from overlapping with the pattern of the upper stepped recess 7, they should be apart from each other by $2\alpha$ (= 0.6 $\mu$m (micron))or more. Further, in order to prevent the patterns of the upper stepped recess 7 and the lower stepped recess 9 from overlapping, the width of the lower stepped recess 9 should be $2\alpha$ (= 0.6 $\mu$m (micron)) or more and the widths of the upper stepped recesses 7a and 7b should be $2\alpha$ (= 0.6 $\mu$m (micron)), more. After all, the source electrode 3 and the drain electrode 4 have to be formed relative to the gate electrode 11 with alignment margin of at least $4\alpha$ (= 1.2$\mu$m (micron)), respectively. This is a great problem for a semiconductor device in which a high frequency characteristic is requested.

In addition, the length of the gate electrode on the lower stepped recess 9 in the direction between the source electrode 3 and the drain electrode 4 is indicated by lg. Since reduction in the gate length largely contributes to an improved high speed and an improved high efficiency of FET, shortening of the gate length is requested. However, according to the conventional fabricating method, since the gate electrode is formed by lift-off using the thick resist films 10a and 10b having an opening at the lower stepped recess 9 as a mask, the section of the gate electrode 11 gradually changes from a trapezoid to a triangle configuration with reduction in the gate length lg, so that the gate area is reduced and the gate resistance is abruptly increased. This results in limitations to the increase of speed of the FET and also a cause of reduction in reliability due to heat generation of the gate electrode.

As described above, while the two-stepped recess FET is of a structure that expects enhancement of the breakdown voltage and high efficiency and has generally been used for the high output FET, the above-described fabrication steps for the conventional two-stepped recess FET has been making it difficult to shorten the source electrode 3-to-gate electrode 11 distance and the drain electrode 4-to-gate electrode 11 distance due to the mask alignment precision of the exposure apparatus and this also made it difficult to improve operation speed to above a certain value. In addition, the miniaturisation of the gate electrode 11 increases the gate resistance, thereby hindering high frequency operation. The reliability is also reduced due to heat generation.

An alternative method of fabricating a semiconductor device having a T-shaped gate electrode in a two-stepped recess is described in United States Patent No. 4,889,827. A layered substrate, having a doped active layer, a metal layer and a first dielectric layer, is etched to produce an upper recess self-aligned with two electrode parts of the metal layer. A second dielectric layer is then produced and etching is performed to produce inner facing dielectric sidewall films and a lower recess self-aligned with these sidewall films. A T-shaped gate electrode is then produced in the lower recess with its shoulder parts on the sidewall films.

## SUMMARY OF THE INVENTION

The present invention is intended as a solution to the problems aforesaid.

A method for fabricating a semiconductor device according to the present invention is set out in claim 1 of the claims appended hereto.

In the foregoing method, the widths of the first sidewall films formed each side of the ohmic electrodes are dependant on the respective thickness of each of these ohmic electrodes. The widths of the second sidewall films are dependant on the respective thickness of each of the ohmic electrodes and on the depth of the upper recess. Since the ohmic electrodes are of different respective thicknesses, an asymmetric offset of the gate electrode relative to the ohmic electrodes therefore results when the gate is produced in abutment with the sidewalls.

The substrate may be of semi-insulating material, for example GaAs.

## BRIEF DESCRIPTION OF THE DRAWINGS

In the accompanying drawings:

Figures 1(a) to 1(f) are cross-sectional views showing a fundamental method for fabricating a semiconductor device;

Figure 2 is a view showing experimental data representing dependency of side wall width on the thickness of an ohmic electrode for explaining the function of the present invention;

Figures 3(a) and 3(b) are cross-sectional views showing a method for fabricating a semiconductor device in accordance with a first embodiment of the present invention;

Figures 4(a) to 4(c) are cross-sectional views showing major steps for fabricating a conventional FET.

## DETAILED DESCRIPTION OF THE PREFERRED EMBODIMENTS

An embodiment of the present invention will be described in detail with reference to the drawings hereinafter. The following description is given by way of example only.

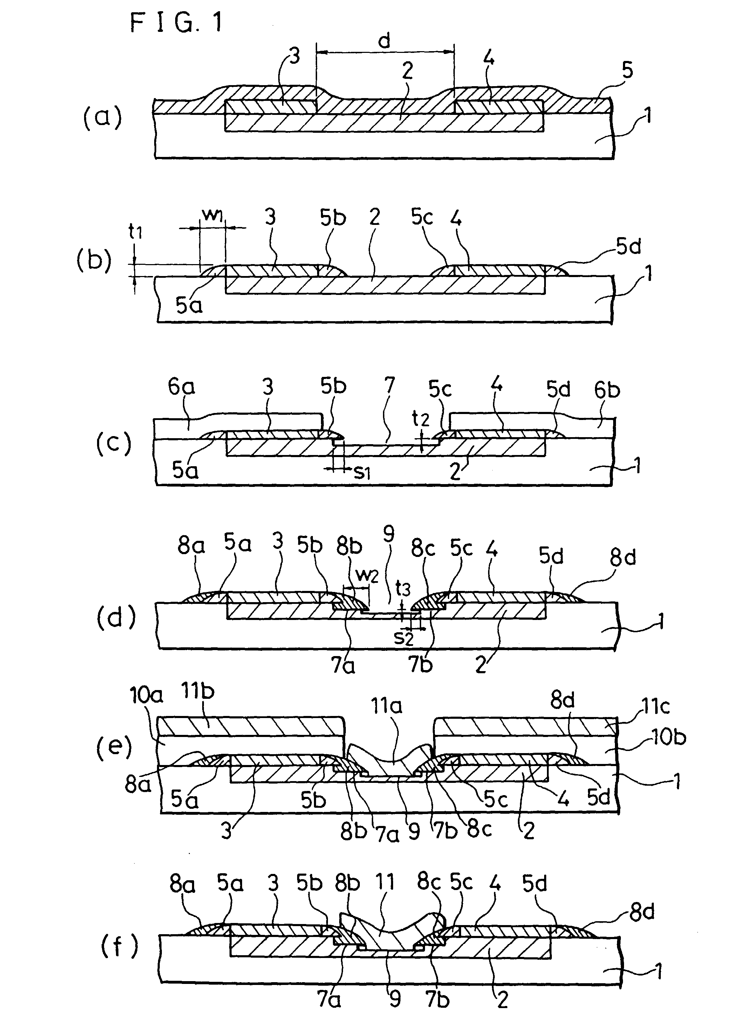

Figure 1 is a view showing major steps of a fundamental method for fabricating a semiconductor device and is described here as a comparative example. In figure 1, a semi-insulating substrate 1 is formed of GaAs or the like. An active layer having an n type impurity is formed in the surface of the GaAs substrate 1. A source electrode 3 and a drain electrode 4 showing ohmic resistance are formed on the active layer 2. Reference numeral 5 designates an insulating film. First side wall films 5a and 5b are formed on both side walls of the source electrode 3. First side wall films 5c and 5d are formed on both side walls of the drain electrode 4. Reference numeral 7 designates an upper stepped recess of two-stepped recess. First resist patterns 6a and 6b are used for forming the upper stepped recess 7. Second side wall films 8a and 8b are formed to be in contact with the first side wall films 5a and 5b on the source electrode 3. Second side wall films 8c and 8d are formed to be in contact with the first insulating films 5c and 5d of the drain electrode 4. Reference numeral 9 designates a lower stepped recess of the two-stepped recess. Second resist patterns 10a and 10b are used for forming the lower stepped recess 9. Reference numerals 11a, 11b and 11c designate gate electrode metals and reference numeral 11 designates a gate electrode.

Next, this fundamental fabricating method will be described below with reference to the drawings.

First, referring to figure 1(a), for example $Si_{29}^{+}$ ions are implanted to a surface of the semi-insulating substrate 1 formed of GaAs or the like by an ion implantation and then the active layer 2 is formed with such a concentration distribution that the surface of the substrate is of high concentration and a rear surface thereof is of low concentration. Thereafter, the source electrode 3 and the drain electrode 4 having the same thickness ($t_1$) are formed of metal such as Au-Ge-Ni so as to be in ohmic contact with the active layer 2 thereon, which are apart from each other by a predetermined dimension (d). Then, the insulating film 5 comprising a silicon dioxide film, a silicon nitride film or the like is deposited on the whole surface to cover the source electrode 3 and the drain electrode 4.

Then, referring to figure 1(b), the insulating film 5 is etched away by dry etching such as RIE (reactive ion etching) and the etching is continued until the surfaces of the source electrode 3 and the drain electrode 4 are exposed, so that the first side wall films 5a and 5b, and 5c and 5d are formed on the both side walls of the source electrode 3 and the drain electrode 4, respectively,

In this case, since the insulating film 5 and the ohmic electrodes 3 and 4 are formed of different materials, etching end point can be easily detected by observing a state of emission of plasma or etched material.

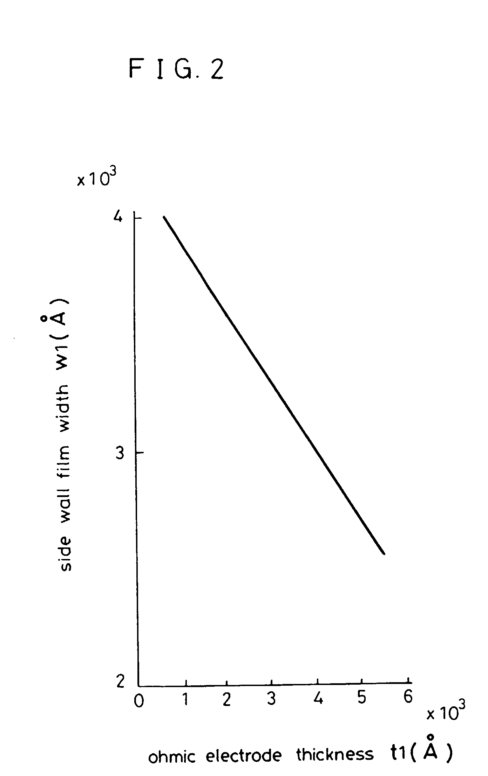

Figure 2 is a graph showing experimental data representing dependency of the side wall width on the thickness of the ohmic electrode. When the thickness of the source electrode 3 and the drain electrode 4 is represented by $t_1$ and the width of the first side wall film is represented by $w_1$, if the thickness of the insulating film 5 is several thousand angstroms, the $t_1$ and $w_1$ are closely related as shown in figure 2. Therefore, the side wall film width ($w_1$) can be well controlled by the ohmic electrode thickness ($t_1$). For example, when the thickness $t_1$ of the ohmic electrode is 400 nm (4000 Angstroms), the width $w_1$ of the first side wall film is approximately 300 nm (3000 Angstroms).

Then, referring to figure 1(c), the resist is formed on the whole surface and then the resist patterns 6a and 6b having the opening pattern between the source electrode 3 and the drain electrode 4 are formed by photolithography.

Since the first side wall films 5a to 5d and the ohmic electrodes 4 and 5 can serve as the etching mask, if at least one end of the resist patterns 6a and 6b covers a part except for the active layer 2 on the substrate and the other end is on the source electrode 3 and the drain electrode 4 or on their side walls 5b and 5d, a large mask alignment margin can be obtained when the resist patterns 6a and 6b are formed.

Then, referring to figure 1(c), the active layer 2 is etched away by $t_2$ in its depth direction by wet etching or dry etching using chlorine group gas by using the resist patterns 6a and 6b and the first side wall films 5b and 5c or together with the ohmic electrodes 3 and 4 as a mask, and then the upper recess 7 is formed. At this time, the upper recess 7 is formed so as to get into lower parts of the side wall films 5b and 5c to some degree ($S_1$) by side etching.

Then, the resists 6a and 6b are removed and the insulating film which covers the source electrode 3 and drain electrode 4 is deposited on the whole surface of the substrate 1 again. Then, it is etched away until the surfaces of the source electrode 3 and the drain electrode 4 are exposed and then the second side wall films 8a to 8d are formed onto the first insulating films 5a to 5d, respectively. In this case, the width ($w_2$) of the second side wall films 8b and 8c is determined by the sum of the thickness ($t_1$) of the ohmic electrode and the depth

($t_2$) of the upper stepped recess as shown in figure 2.

Then, referring to figure 1(d), a part other than a part where the lower stepped recess is formed is protected by the second resist pattern (not shown) and the lower stepped recess 9 is formed by etching the opening by a depth $t_3$ by wet etching or RIE using chlorine group gas, using the second side wall films 8b and 8c as a mask. At this time, the lower stepped recess 9 is formed so as to get into lower parts of the insulating films 8b and 8c by $S_2$ by side etching. Then, the resist is removed.

According to the second resist pattern, if the end of the opening is positioned on the second side wall insulating films 8b and 8c or the first side wall insulating films 5b and 5c or the ohmic electrodes 3 and 4 like the first resist pattern, a large alignment margin can be obtained for the patterning.

Then, referring to figure 1(e), in order to form the gate electrode, the third resist patterns 10a and 10b having its opening end on the first side wall films 5b and 5c or the second side wall films 8b and 8c are provided and then a gate electrode metal is deposited on the whole surface of the substrate 1. The gate electrode metal 11b, 11c and 11a are formed apart from each other on the resist patterns 10a, 10b and the lower stepped recess 9, respectively.

Then, referring to figure 1(f), the third resist 10a and 10b and the gate metal 11b and 11c are removed by lift-off and an FET having a self-alignment T-shaped gate electrode 11 formed on the lower stepped portion of two-stepped recess is completed.

According to the fabricating method shown in figure 1, a large mask alignment margin can be obtained when the first mask patterns 6a and 6b and the second mask patterns 10a and 10b are formed. In addition, when the third mask patterns 10a and 10b are formed, the mask alignment margin of the sum ($w_1 + w_2$) of the first and second side wall film widths can be obtained. Therefore, according to this method, those patterns can be easily formed and the size of the upper and lower stepped recesses can be a desired value by adjusting the widths of the first and second side wall films regardless of the alignment precision of the exposure apparatus.

In this case, the distance between the ohmic electrode 3 or 4 and the gate electrode 11 is the sum of the first side wall film width $w_1$ and the second side wall film width $w_2$.

For example, when the thickness $t_1$ of the ohmic electrodes 3 and 4 is 0.4 μm (micron) and depths $t_2$ and $t_3$ of the upper and lower stepped recesses are 0.1 micron, the first and second side wall film widths $w_1$ and $w_2$ are approximately 0.3 μm (micron) and 0.26 μm (micron), respectively. Therefore, when the distances between a position where the gate electrode is in contact with the lower stepped recess and the ohmic electrode are $l_{GS}$ and $l_{GD}$, both $l_{GS}$ and $l_{GD}$ become 0.56 micron (= 0.3 μm (micron) + 0.26 μm (micron), which can be considerably small as compared with the conventional example.

In addition, according to this fabricating method, the gate length can be easily reduced. For example, if the gate length lg is to be 0.2 μm (micron), the distance d between the ohmic electrodes should be approximately 1.32μm (micron) because d = lg + 2 ($w_1$ + $w_2$) and the above steps may be carried out.

As described above, according to the fabricating method shown in figure 1, since the upper stepped recess 7 and the lower stepped recess 9 are formed in a self-alignment manner with the ohmic electrodes 3 and 4 by using the first and second side wall films, the distance between the gate and the source and the distance between the gate and the drain can be determined like the prior art regardless of the alignment precision of the exposure apparatus and especially, the source resistance can be reduced by reducing the distance between the source and the gate.

In addition, according to the fabricating method shown in figure 1, since the gate electrode 11 has a T-shaped structure, even if the gate length is reduced, a section area of the gate can be increased, resulting in no increase in the gate resistance and reliability of the device is assured.

Next, a method for fabricating a high power FET in accordance with a first embodiment of the present invention, to which the fabricating method shown in figure 1 is applied, will be described in reference to the drawings.

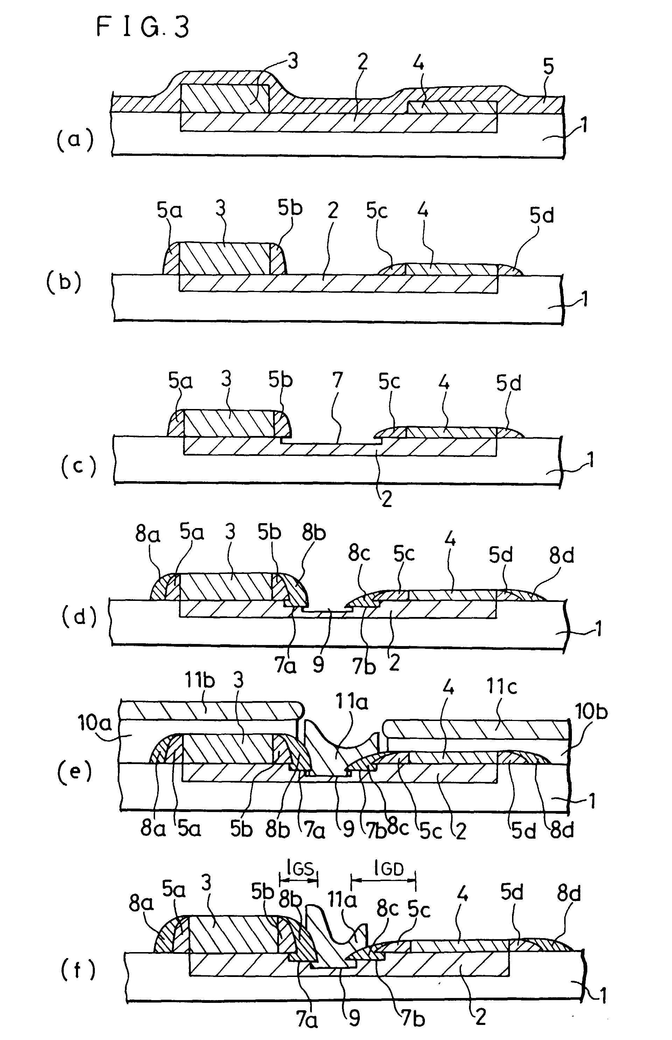

Figure 3 are sectional views showing main steps for fabricating a semiconductor device in accordance with a first embodiment of the present invention, more particularly an FET having two-stepped recess T-shaped offset gate structure. In figure 3, the same reference numerals as in figure 1 designate the same parts.

According to this embodiment of the present invention, the thicknesses of the source electrode 3 and the drain electrode 4 are differentiated from those obtained in the source and drain electrodes production step in the method shown in figure 1, as shown in figure 3(a), whereby the width of the first side wall film 5 is set at a value obtained from the relation shown in figure 2. In this embodiment, the source electrode 3 is formed thick and the drain electrode 4 is formed thin, whereby the widths of the first side wall films 5a and 5b on the source electrode 3 are reduced and the widths of the first side wall films 5c and 5d on the drain electrode 4 are increased as shown in figure 3(b).

Thereafter, as shown in figures 3(c) to 3(f), the same steps as in the fabricating method shown in figure 1 follow and a structure shown in figure 3(f) is obtained.

When the distances between the position where the gate electrode 11 is in contact with the lower stepped recess 9 and the source electrode 3 or the drain electrode 4 are represented by $l_{GS}$ and $l_{GD}$, the $l_{GS}$ and $l_{GD}$ can be controlled by the thicknesses of the source electrode 3 and the drain electrode 4 as shown by the relation in figure 2.

Therefore, according to this embodiment of the present invention, similar to the fabricating method shown in figure 1, the gate electrode 11 and the upper and lower stepped recesses can be formed in a self-alignment manner with the ohmic electrodes 3 and 4 at predetermined offset intervals and the distance between the ohmic electrodes 3 and 4 and the gate electrode 11 can be reduced and the gate resistance is also reduced. Furthermore, in addition to the above effects, the distance between the gate and the drain can be larger than that between the gate and the source, whereby the gate-to-drain breakdown voltage can be enhanced and then a high output of the FET can be implemented.

Although a GaAs substrate is used as the semi-insulating substrate in the above embodiment of the present invention, another group III - V compound semiconductor or another semi-insulating substrate or a semiconductor substrate may be used. In addition, the substrate may be formed of a plurality of layers.

As described above, according to the present invention, since the upper and lower stepped recesses and the gate electrode are formed using side wall films formed adjacent to the ohmic electrodes as a mask, the upper and lower stepped recesses and the gate electrode can be finely formed in a self-alignment manner with the side wall films regardless of mask alignment precision of an exposure apparatus of photolithography. This results in a reduced gate electrode to ohmic electrode distance, a reduced gate to source resistance, and thereby a high sped operation device. In addition, since the configuration of the gate electrode is T-shaped, the gate resistance can be reduced and then high reliability of the gate can be assured. Furthermore, since multiple-stepped recesses are provided, the breakdown voltage of the element can be enhanced. Therefore, the recesses and the gate electrode can be finely formed in a self-alignment manner with the side wall films of the ohmic electrodes without precise photolithography technique, whereby an FET having a high breakdown voltage and a high speed performance can be obtained by a simple fabricating method.

The thicknesses of the ohmic electrodes are made different. When it is the drain electrode that is thinner than the source electrode, an effect is obtained further that, the distance between the gate and the drain is larger than the difference between the gate and the source, thereby resulting in a reduced gate to source resistance and a reduced gate to drain breakdown voltage and this results in a high output of the FET.

Although the present invention has been described and illustrated in detail, it is clearly understood that the same is by way of illustration and example only and is not to be taken by way of limitation, the scope of the present invention being limited only by the terms of the appended claims.

## Claims

1. A method of fabricating a semiconductor device having an offset T-shaped gate electrode (11,11a) in a two-stepped recess (7,9) comprising the steps of:

    forming an active layer (2) in the surface of a compound semiconductor substrate (1);
    forming two ohmic electrodes (3,4) for source and drain respectively having different thicknesses from each other, side-by-side, on said active layer (2);
    forming first side wall films (5a & 5b, 5c & 5d) on the side walls of said two ohmic electrodes (3, 4);
    forming an upper stepped recess (7) between said ohmic electrodes by etching said active layer using said first side wall films (5b, 5c) as a mask;
    forming second side wall films (8b, 8c) in contact with said first side wall films (5b, 5c) with the second sidewall films between said ohmic electrodes extending into said upper stepped recess (7);
    forming a lower stepped recess (9) by etching said active layer (2) exposed at the surface of said upper stepped recess (7) using said second side wall films (5b,5c) as a mask; and
    forming said offset T-shaped gate electrode (11a) in said lower stepped recess (9) with its shoulder parts on said second side wall films (8b, 8c), wherein said offset T-shaped gate electrode (11,11a) contacts said active layer (2) and is offset from each of said two ohmic electrodes (3,4) by different distances dependent on the different respective thicknesses of said two ohmic electrodes (3,4).

2. A method of fabricating a semiconductor device in accordance with claim 1 wherein said compound semiconductor substrate (1) is a semi-insulating compound semiconductor substrate.

3. A method of fabricating a semiconductor device in accordance with claim 2 wherein said compound semiconductor substrate (1) is of GaAs.

## Patentansprüche

1. Verfahren zur Herstellung einer Halbleitervorrichtung mit einer versetzten T-förmigen Gateelektrode (11, 11a) in einer zweifach-abgestuften Aussparung (7, 9), bestehend aus den Schritten:

    Ausbilden einer aktiven Schicht (2) an der Oberfläche eines Verbindungshalbleiter-Substrats (1);
    Ausbilden von zwei ohmschen Elektroden (3, 4) für eine jeweilige Source und Drain mit zueinander unterschiedlichen Dicken, die Seite an Seite auf der aktiven Schicht (2) liegen;
    Ausbilden von ersten Seitenwandschichten (5a und 5b, 5c und 5d) an den Seitenwänden der zwei ohmschen Elektroden (3, 4);
    Ausbilden einer oberen abgestuften Aussparung (7) zwischen den ohmschen Elektroden mittels Ätzen der aktiven Schicht, wobei die ersten Seitenwandschichten (5b, 5c) als eine Maske verwendet werden;
    Ausbilden von zweiten Seitenwandschichten (8b, 8c) in Kontakt mit den ersten Seitenwandschichten (5b, 5c), wobei sich die zweiten Seitenwandschichten zwischen den ohmschen Elektroden in die obere abgestufte Aussparung (7) erstrecken;
    Ausbilden einer unteren abgestuften Aussparung (9) durch Ätzen der aktiven Schicht (2), die an der Oberfläche der oberen abgestuften Aussparung (7) freiliegt, wobei die zweiten Seitenwandschichten (5b, 5c) als eine Maske verwendet werden; und
    Ausbilden der versetzten T-förmigen Gateelektrode (11a) in der unteren abgestuften Aussparung (9), bei der die Schulterabschnitte auf den zweiten Seitenwandschichten (8b, 8c) liegen, wobei die versetzte T-förmige Gateelektrode (11, 11a) in Kontakt mit der aktiven Schicht (2) ist und von jeder der zwei ohmschen Elektroden (3, 4) um unterschiedliche Abstände in Abhängigkeit von den jeweiligen unterschiedlichen Dicken der beiden ohmschen Elektroden (3, 4) versetzt ist.

2. Verfahren zur Herstellung einer Halbleitervorrichtung nach Patentanspruch 1, wobei das Verbindungshalbleitersubstrat (1) ein halbisolierendes Verbindungshalbleitersubstrat ist.

3. Verfahren zur Herstellung einer Halbleitervorrichtung nach Patentanspruch 2, wobei das Verbindungshalbleitersubstrat (1) aus GaAs besteht.

## Revendications

1. Procédé de fabrication d'un dispositif à semiconducteur ayant une électrode de grille formée en T décalée (11, lla) dans un évidement en deux échelons (7, 9) comprenant les étapes de :

    former une couche active (2) dans la surface d'un substrat semiconducteur composé (1) ;
    former deux électrodes ohmiques (3, 4) ou respectivement une source et un drain ayant des épaisseurs différentes les unes des autres, côte à côte, sur ladite couche active (2) ;

former des premiers films de parois latérales (5a & 5b, 5c & 5d) sur les parois latérales desdites deux électrodes ohmiques (3, 4) ;

former un évidement supérieur en échelon (7) entre lesdites électrodes ohmiques en attaquant ladite couche active utilisant lesdits premiers films de parois latérales (5b, 5c) comme masque ;

former des seconds films de parois latérales (8b, 8c) en contact avec lesdits premiers films de parois latérales (5b, 5c) avec les seconds films de parois latérales entre lesdites électrodes ohmiques s'étendant dans ledit évidement supérieur en échelon (7) ;

former un évidement inférieur en échelon (9) en attaquant ladite couche active (2) exposée à la surface dudit évidement supérieur en échelon (7) utilisant lesdits seconds films de parois latérales (5b, 5c) comme masque ; et

former ladite électrode de grille conformée en T décalée (11a) dans ledit évidement inférieur en échelon (9) avec ses parties d'épaulement sur lesdits seconds films de parois latérales (8b, 8c), où ladite électrode de grille conformée en T décalée (11, 11a) contacte ladite couche active (2) et est décalée de chacune desdites deux électrodes ohmiques (3, 4) de distances différentes dépendant des épaisseurs respectives différentes des deux électrodes ohmiques (3, 4).

2. Procédé de fabrication d'un dispositif à semiconducteur selon la revendication 1 dans lequel le substrat semiconducteur composé précité (1) est un substrat semiconducteur composé semi-isolant.

3. Procédé de fabrication d'un dispositif à semiconducteur selon la revendication 2 dans lequel le substrat semiconducteur composé précité (1) est du GaaS.

# F I G. 1

F I G. 2

FIG. 3

FIG.4(PRIOR ART)

(a)

(b)

(c)